(19) Europäisches Patentamt
European Patent Office
Office européen des brevets

(11) EP 4 564 027 A1

(12) EUROPEAN PATENT APPLICATION
published in accordance with Art. 153(4) EPC

(43) Date of publication:
04.06.2025 Bulletin 2025/23

(21) Application number: 23939202.0

(22) Date of filing: 22.09.2023

(51) International Patent Classification (IPC):
G01R 31/367 (2019.01)      B60L 58/12 (2019.01)
G01R 31/382 (2019.01)

(52) Cooperative Patent Classification (CPC):
Y02T 10/70

(86) International application number:
PCT/CN2023/120750

(87) International publication number:
WO 2024/244228 (05.12.2024 Gazette 2024/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 26.05.2023 CN 202310612960

(71) Applicant: Deepal Automobile Technology Co.,
Ltd.
Chongqing 401133 (CN)

(72) Inventors:
• LI, Zonghua
  Chongqing 401135 (CN)
• LI, Dongjiang
  Chongqing 401135 (CN)

(74) Representative: DREISS Patentanwälte PartG
mbB
Friedrichstraße 6
70174 Stuttgart (DE)

(54) REAL-TIME CORRECTION METHOD FOR SOC OF BATTERY, SERVER, APPARATUS, VEHICLE, AND MEDIUM

(57) The present application relates to a real-time correction method for the SOC of a battery, a server, an apparatus, a vehicle, and a medium. The method comprises: inputting battery data uploaded by a current vehicle into a preset electrochemical model to obtain a cloud SOC of a battery; and it is determined that the absolute value of the difference between the cloud SOC and a vehicle SOC at an uploading moment is greater than a first preset value, and a full charge correction flag and a full discharge correction flag are each a second preset value, sending the cloud SOC to the current vehicle, so that the current vehicle corrects the current vehicle SOC according to the cloud SOC, a capacity accumulation throughput at a cloud SOC receiving moment and a vehicle capacity accumulation throughput at the uploading moment. Thus, the present application solves the problem that the SOC cannot be corrected in real time when the use interval of a user is a voltage plateau region and the SOC error in the whole use interval of the battery is large, the calculation error of the SOC is corrected in real time, and user experience is enhanced.

FIG. 1

**Description**

## CROSS-REFERENCE TO RELATED APPLICATION

This application is submitted based on and claims priority to Chinese patent application No. 202310612960.2, filed on May 26, 2023, the entire disclosure of which is incorporated herein by reference.

## TECHNICAL FIELD

The present disclosure relates to the field of vehicle battery management technology, and in particular to a method for correcting a State of Charge, SOC, of a battery in real time, a server, an apparatus, a vehicle, and a medium.

## BACKGROUND

SOC of a battery is one of the most important control parameters of a Battery Management System, BMS, which directly affects safety of battery use. Therefore, an accurate estimation of a SOC is a very important task of the BMS. At present, commonly used methods for calculating the SOC in an industry include an Ampere Hour Integration Method, an OCV Look-Up Table Method, an Extended Kalman Filter Algorithm, etc. A calculation process of almost all algorithms is related to a battery charge and discharge voltage curve. If a voltage curve has high monotonicity, a SOC value calculated by the algorithm is more accurate. If linearity of the voltage curve is not high, such as a LFP battery, a traditional algorithm cannot accurately obtain a SOC value of an entire using interval. Therefore, in a practical application of the LFP battery, a traditional SOC algorithm can be combined with some special correction strategies to make up for shortcomings of the algorithm.

In the related art, a patent [CN202211405418.1] provides a method for correcting a state of charge of a lithium iron phosphate battery, an apparatus for correcting the state of charge of the lithium iron phosphate battery, an electronic device, a computer-readable storage medium, a computer program, and a vehicle. The method for correcting the state of charge of the lithium iron phosphate battery includes: obtaining state information of the battery; the state information of the battery including at least the state of charge of the battery and a state of use of the battery; based on the state information of the battery, transmitting a correction request identifier requesting to enter a state of charge correction mode, allowing the state of charge of the battery to be adjusted to fall within a predetermined charge range; in response to the state of charge of the battery being adjusted to fall within the predetermined charge range, re-obtaining the state of charge of the battery and using it as a corrected state of charge of the battery.

However, this method can only correct a SOC error subsequent to the SOC error has accumulated to a certain extent, and cannot correct the SOC of the battery in real time. More importantly, this method requires a user to cooperate and operate, which affects normal vehicle using habits and experience of the user.

A patent [CN201310630382.1] provides a method for correcting a SOC by using an OCV-SOC curve. The method corrects the SOC of the lithium iron phosphate battery based on an Open Circuit Voltage Method and the Ampere Hour Integration Method. The method specifically includes: turning on to detect battery standing time T; determining whether the battery standing time T exceeds a predetermined limit; executing a next operation when the battery standing time exceeds the predetermined limit; obtaining lowest cell voltage of the battery cellv_min and a current SOC value; disposing at least three feature points Pn and corresponding and appropriately low SOC values SOCn at a relatively flat interval of the OCV-SOC curve; comparing and determining the lowest cell voltage of the battery cellv_min with a voltage value cellv_n of each feature point, and correcting the SOC value.

However, conditions for triggering correction proposed by the method are extremely harsh, and probability that the SOC of the battery in the interval proposed by the method is extremely small in an actual power-down process of the user, which makes the application of the method somewhat limited.

## SUMMARY

One of objects of the present disclosure is to provide a method for correcting a State of Charge, SOC, of a battery in real time. The method is applied in a server to solve problems in the related art that a SOC cannot be corrected in real time in actual working conditions and a SOC error in an entire using interval of the battery is large. A second object is to provide a method for correcting the SOC of the battery in real time, the method being applied in a vehicle. A third object is to provide a server. A fourth object is to provide an apparatus for correcting the SOC of the battery in real time. A fifth object is to provide a vehicle. A sixth object is to provide a computer-readable storage medium.

To achieve the above-described objects, technical solutions adopted in the present disclosure are as follows.

Provided is a method for correcting a SOC of a battery in real time. The method is applied in a server. The method includes: receiving battery data uploaded by a current vehicle, the battery data including a vehicle SOC at an upload time point, a vehicle cumulative throughput capacity at the upload time point, a full charge correction flag at the upload time point, and a full discharge correction flag at the upload time point; inputting the battery data into a predetermined electrochemical model to obtain a cloud SOC of the battery, and determining whether an absolute value of a difference between the cloud SOC and the vehicle SOC at the upload time point is greater than a first predetermined value and whether the full charge correction flag and the full discharge correction flag are both of a second predetermined value; and when the absolute value of the difference between the cloud SOC and the vehicle SOC at the upload time point is greater than the first predetermined value and the full charge correction flag and the full discharge correction flag are both of the second predetermined value, transmitting the cloud SOC to the current vehicle, allowing the current vehicle to correct a current vehicle SOC based on the cloud SOC, a cumulative throughput of capacity at a time point of receiving the cloud SOC, and the vehicle cumulative throughput of capacity at the upload time point.

Based on the above-described technical means, in the present disclosure, a vehicle and cloud integration method is adopted to obtain the cloud SOC of the battery by using an electrochemical model deployed on a cloud. A difference between the vehicle SOC and the cloud SOC is compared with a determined calibration value. An error of the SOC calculated by a vehicle BMS is corrected in real time based on a comparison result and combined with a cumulative throughput. In this way, accuracy of correcting the SOC of the battery is improved and user experience is enhanced.

Further, the battery data further includes a charge voltage curve and a discharge voltage curve.

The predetermined electrochemical model includes a temperature field model, an internal resistance model, an electro motive force model, and an equivalent circuit model.

Based on the above-described technical means, the battery data provided in the present disclosure includes the vehicle SOC at the upload time point, the vehicle cumulative throughput of capacity at the upload time point, the full charge correction flag at the upload time point, the full discharge correction flag at the upload time point, the charge voltage curve, and the discharge voltage curve, which are used as input parameters of the electrochemical model. The cloud can perform a data calculation based on the battery data and the electrochemical model, and obtains the cloud SOC of the battery. In this way, the cloud SOC of the battery can be used to timely correct an error of the vehicle SOC calculated by a BMS, further enhancing the user experience.

Further, said inputting the battery data into the predetermined electrochemical model to obtain the cloud SOC of the battery includes: calculating a real-time temperature of the battery based on the temperature field model, and calculating an internal resistance of the battery based on the internal resistance model and the real-time temperature; calculating an electro motive force during charging of the battery and an electro motive force during discharging of the battery based on the electro motive force model, the charge voltage curve, and the discharge voltage curve; and calculating the cloud SOC of the battery based on the equivalent circuit model using the internal resistance, the electro motive force during the charging, and the electro motive force during the discharging.

Based on the above-described technical means, in the present disclosure, the cloud SOC of the battery is calculated through the temperature field model, the internal resistance model, the electro motive force model, and the equivalent circuit model, which serves as a basis for correcting the current vehicle SOC. In this way, the problem that the SOC error in the entire using interval of the battery is large can be solved.

Further, the equivalent circuit model is:

$$V_{ch}\left(x_0 + \frac{\int_0^t I dt}{Q_b}\right) - IR\left(\frac{Q_0}{Q_b}\frac{\int_0^t I dt}{Q_0}, I\right) = V_{EMF}^{ch}\left(\frac{Q_0}{Q_b}\frac{\int_0^t I dt}{Q_0}\right),$$

or

$$V_{d}\left(x_0 + \frac{\int_0^t I dt}{Q_b}\right) - IR\left(\frac{Q_0}{Q_b}\frac{\int_0^t I dt}{Q_0}, I\right) = V_{EMF}^{d}\left(\frac{Q_0}{Q_b}\frac{\int_0^t I dt}{Q_0}\right),$$

where $V_{ch}$ represents an actual charge voltage curve of the battery, $V_d$ represents an actual discharge voltage curve of the battery, $x_0$ represents a SOC value at a time point of uploading the battery data, $Q_0$ represents an initial capacity of a battery cell, $Q_b$ represents a real capacity of the battery cell at any time point, I represents a real-time current value of the battery, R represents the internal resistance of the battery, $V_{EMF}^{ch}$ represents the electro motive force during the charging, and $V_{EMF}^{d}$ represents the electro motive force during the discharging.

Based on the above-described technical means, in the present disclosure, the cloud SOC of the battery can be calculated through the equivalent circuit model. In this way, an error of the SOC calculated by the BMS is corrected based on the cloud SOC, improving accuracy of correcting the current vehicle SOC.

Further, the electro motive force model is:

$$V_{EMF}^{ch} = V_{ch} - \eta_{ch};$$

and

$$V_{EMF}^{d} = V_{d} + \eta_{d},$$

where $\eta_{ch}$ represents charge overpotential, and $\eta_{d}$ represents discharge overpotential.

Based on the above-described technical means, in the present disclosure, a charge and discharge electro motive force can be calculated through the electro motive force model. In this way, the error of the SOC calculated by the BMS is corrected in combination with the charge and discharge electromotive force, improving the accuracy of correcting the current vehicle SOC.

Further, the vehicle SOC at the upload time point is:

$$BCUSOC(t_1) = x_0 + \frac{\int_0^{t_1} I dt}{Q_0},$$

where $x_0$ represents a SOC value of a battery system at an initial time point, $Q_0$ represents a battery standard capacity, and $t_1$ represents a time.

The vehicle cumulative throughput of capacity at the upload time point is:

$$Q_{accAH}(t_1) = Q_{accAH}^0 + \int_0^{t_1} I dt,$$

where $Q_{accAH}^0$ represents a cumulative charge and discharge capacity at the initial time point.

Based on the above-described technical means, in the present disclosure, the vehicle cumulative throughput of capacity at the upload time point can be calculated through the above equation. In this way, the error of the SOC calculated by the BMS can be corrected in combination with the cumulative throughput of capacity at the time point of receiving the cloud SOC, improving the accuracy of correcting the current vehicle SOC.

Provided is a method for correcting a State of Charge, SOC, of a battery in real time. The method is applied in a vehicle and includes: uploading battery data of a current vehicle to a server, the battery data including a vehicle SOC at an upload time point, a vehicle cumulative throughput of capacity at the upload time point, a full charge correction flag at the upload time point, and a full discharge correction flag at the upload time point; receiving a cloud SOC, the cloud SOC being transmitted by the server based on the vehicle SOC at the upload time point, the vehicle cumulative throughput of capacity at the upload time point, the full charge correction flag at the upload time point, and the full discharge correction flag at the upload time point; and correcting a current vehicle SOC based on the cloud SOC, a cumulative throughput of capacity at a time point of receiving the cloud SOC, and the vehicle cumulative throughput of capacity at the upload time point.

Further, said correcting the current vehicle SOC based on the cloud SOC, the cumulative throughput of capacity at the time point of receiving the cloud SOC, and the vehicle cumulative throughput of capacity at the upload time point includes: calculating a difference between the cumulative throughput of capacity at the time point of receiving the cloud SOC and the vehicle cumulative throughput of capacity at the upload time point; calculating a ratio of the difference between the cumulative throughput of capacity at the time point of receiving the cloud SOC and the vehicle cumulative throughput of capacity at the upload time point to a battery standard capacity, and obtaining a SOC correction value of the battery based on a sum of the ratio and the cloud SOC; and correcting the SOC of the battery based on the SOC correction value.

Provided is a server. The server includes: a first receiving module configured to receive battery data uploaded by a current vehicle, the battery data including a vehicle SOC at an upload time point, a vehicle cumulative throughput of capacity at the upload time point, a full charge correction flag at the upload time point, and a full discharge correction flag at the upload time point; a determining module configured to input the battery data into a predetermined electrochemical model to obtain a cloud SOC of the battery, and determine whether an absolute value of a difference between the cloud SOC and the vehicle SOC at the upload time point is greater than a first predetermined value and whether the full charge correction flag and the full discharge correction flag are both of a second predetermined value; and a transmitting module configured to transmit the cloud SOC to the current vehicle when the absolute value of the difference between the cloud SOC and the vehicle SOC at the upload time point is greater than the first predetermined value and the full charge correction flag and the full discharge correction flag are both of the second predetermined value, allowing the current vehicle to correct a current vehicle SOC based on the cloud SOC, a cumulative throughput of capacity at a time point of receiving the cloud SOC, and the vehicle cumulative throughput of capacity at the upload time point.

Further, the battery data further includes a charge voltage curve and a discharge voltage curve.

The predetermined electrochemical model includes a temperature field model, an internal resistance model, an electro motive force model, and an equivalent circuit model.

Further, the determining module is configured to: calculate a real-time temperature of the battery based on the temperature field model, and calculate an internal resistance of the battery based on the internal resistance model and the real-time temperature; calculate an electro motive force during charging of the battery and an electro motive force during discharging of the battery based on the electro motive force model, the charge voltage curve, and the discharge voltage curve; and calculate the cloud SOC of the battery based on the equivalent circuit model using the internal resistance, the electro motive force during the charging, and the electro motive force during the discharging.

Further, the equivalent circuit model is:

$$V_{ch}\left(x_0 + \frac{\int_0^t I\,dt}{Q_b}\right) - IR\left(\frac{Q_0}{Q_b}\frac{\int_0^t I\,dt}{Q_0}, I\right) = V_{EMF}^{ch}\left(\frac{Q_0}{Q_b}\frac{\int_0^t I\,dt}{Q_0}\right),$$

or

$$V_d\left(x_0 + \frac{\int_0^t I\,dt}{Q_b}\right) - IR\left(\frac{Q_0}{Q_b}\frac{\int_0^t I\,dt}{Q_0}, I\right) = V_{EMF}^d\left(\frac{Q_0}{Q_b}\frac{\int_0^t I\,dt}{Q_0}\right),$$

where $V_{ch}$ represents an actual charge voltage curve of the battery, $V_d$ represents an actual discharge voltage curve of the battery, $x_0$ represents a SOC value at a time point of uploading the battery data, $Q_0$ represents an initial capacity of a battery cell, $Q_b$ represents a real capacity of the battery cell at any time point, I represents a real-time current value of the battery, R represents the internal resistance of the battery, $V_{EMF}^{ch}$ represents the electro motive force during the charging, and $V_{EMF}^d$ represents the electro motive force during the discharging.

Further, the electro motive force model is:

$$V_{EMF}^{ch} = V_{ch} - \eta_{ch};$$

and

$$V_{EMF}^d = V_d + \eta_d,$$

where $\eta_{ch}$ represents charge overpotential, and $\eta_d$ represents discharge overpotential.

Further, the vehicle SOC at the upload time point is:

$$BCUSOC(t_1) = x_0 + \frac{\int_0^{t_1} I\,dt}{Q_0},$$

where $x_0$ represents a SOC value of a battery system at an initial time point, $Q_0$ represents a battery standard capacity, and $t_1$ represents a time.

The vehicle cumulative throughput of capacity at the upload time point is:

$$Q_{accAH}(t_1) = Q_{accAH}^0 + \int_0^{t_1} I dt ,$$

where $Q_{accAH}^0$ represents a cumulative charge and discharge capacity at the initial time point.

An apparatus for correcting a State of Charge, SOC, of a battery in real time, the apparatus is applied in a vehicle and includes: an upload module configured to upload battery data of a current vehicle, and transmit the battery data to a server, the battery data including a vehicle SOC at an upload time point, a vehicle cumulative throughput of capacity at the upload time point, a full charge correction flag at the upload time point, and a full discharge correction flag at the upload time point; a second receiving module configured to receive a cloud SOC, the cloud SOC being transmitted by the server based on the vehicle SOC at the upload time point, the vehicle cumulative throughput of capacity at the upload time point, the full charge correction flag at the upload time point, and the full discharge correction flag at the upload time point; and a correction module configured to correct a current vehicle SOC based on the cloud SOC, a cumulative throughput of capacity at a time point of receiving the cloud SOC, and the vehicle cumulative throughput of capacity at the upload time point.

Further, the correction module is configured to: calculate a difference between the cumulative throughput of capacity at the time point of receiving the cloud SOC and the vehicle cumulative throughput of capacity at the upload time point; calculate a ratio of the difference between the cumulative throughput of capacity at the time point of receiving the cloud SOC and the vehicle cumulative throughput of capacity at the upload time point to a battery standard capacity, and obtain a SOC correction value of the battery based on a sum of the ratio and the cloud SOC; and correct the SOC of the battery based on the SOC correction value.

Provided is a vehicle. The vehicle includes the above-described apparatus for correcting the SOC of the battery in real time.

Provided is a computer-readable storage medium. The computer-readable storage medium stores a computer program. The computer program, when executed by a processor, implements the method for correcting the SOC of the battery in real time according to the embodiments of one of the object or the method for correcting the SOC of the battery in real time according to the embodiments of the second object.

In the present disclosure, the battery data of the current vehicle is input into the predetermined electrochemical model to obtain the cloud SOC. When the absolute value of the difference between the cloud SOC and the vehicle SOC at the upload time point is determined to be greater than the first predetermined value and the full charge correction flag and the full discharge correction flag are both of the second predetermined value, the current vehicle SOC is corrected based on the cloud SOC, the cumulative throughput of capacity at the time point of receiving the cloud SOC, and the vehicle cumulative throughput of capacity at the upload time point. In this way, a problem that the SOC cannot be corrected in real time when an using interval of a user is a voltage platform region and the problem that the SOC error in the entire using interval of the battery is large are solved, which corrects a calculation error of the SOC in real time and improves the user experience.

Additional aspects and advantages of the present disclosure will be provided at least in part in the following description, or will become apparent at least in part from the following description, or can be learned from practicing of the present disclosure.

## BRIEF DESCRIPTION OF DRAWINGS

The above and/or additional aspects and advantages of the present disclosure will become more apparent and more understandable from the following description of embodiments taken in conjunction with the accompanying drawings.

FIG. 1 is a flowchart of a method for correcting a SOC of a battery in real time according to the embodiments of the present disclosure.
FIG. 2 is a flowchart of a method for correcting a SOC of a battery in real time according to an embodiment of the present disclosure.
FIG. 3 is a flowchart of another method for correcting a SOC of a battery in real time according to the embodiments of the present disclosure.
FIG. 4 is a block diagram of a server according to the embodiments of the present disclosure.
FIG. 5 is a block diagram of an apparatus for correcting a SOC of a battery in real time according to the embodiments of the present disclosure.

Where, 10-server, 100-first receiving module, 200-determining module, 300-transmitting module, 20-apparatus for correcting a SOC of a battery in real time, 400-upload module, 500-second receiving module, 600-correction module.

## DESCRIPTION OF THE EMBODIMENTS

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limit, the present disclosure.

Before introducing a method for correcting a SOC of a battery in real time provided in embodiments of the present disclosure, common correction strategies in the related art will be briefly introduced.

In the related art, commonly used correction strategies include full charge correction and full discharge correction, that is, a SOC is corrected to 100% when charging reaches cut-off voltage, or the SOC is corrected to 0 when discharging reaches the cut-off voltage. The full charge correction and the full discharge correction can correct back an ampere hour integration error accumulated during use of a LFP battery.

However, in actual user working conditions, especially in user working conditions of extended range vehicles, the full charge correction and the full discharge correction rarely occur, which is impossible for a user to avoid a control problem caused by an inaccurate SOC calculation in most usage scenarios.

Based on this, in the embodiments of the present disclosure, a method for correcting a SOC of a battery in real time is provided. Battery data of a current vehicle is input into a predetermined electrochemical model to obtain a cloud SOC. When an absolute value of a difference between the cloud SOC and a vehicle SOC at an upload time point is determined to be greater than a first predetermined value and a full charge correction flag and a full discharge correction flag are both of a second predetermined value, a current vehicle SOC is corrected based on the cloud SOC, the cumulative throughput of capacity at a time point of receiving the cloud SOC, and the vehicle cumulative throughput of capacity at the upload time point. In this way, a problem that the SOC cannot be corrected in real time when an using interval of the user is a voltage platform region and a problem that a SOC error in an entire using interval of the battery is large are solved, which corrects a calculation error of the SOC in real time and improves user experience.

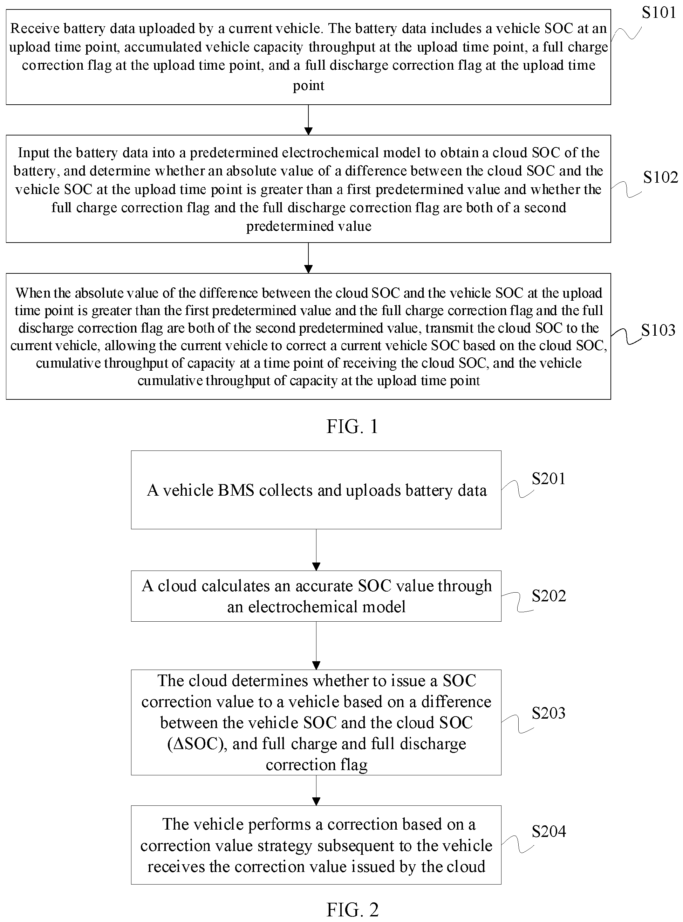

Specifically, FIG. 1 is a flowchart of a method for correcting a SOC of a battery in real time according to the embodiments of the present disclosure.

As illustrated in FIG. 1, the method for correcting the SOC of the battery in real time is applied in a server and includes following steps.

In step S101, receive the battery data uploaded by the current vehicle. The battery data includes the vehicle SOC at the upload time point, the vehicle cumulative throughput of capacity at the upload time point, the full charge correction flag at the upload time point, and the full discharge correction flag at the upload time point.

In some embodiments, the vehicle SOC at the upload time point is:

$$\text{BCUSOC}(t_1) = x_0 + \frac{\int_0^{t_1} I dt}{Q_0} \quad , \tag{1}$$

where $x_0$ represents a SOC value of a battery system at an initial time point, $Q_0$ represents a battery standard capacity, $I$ represents a real-time current value of the battery, and $t_1$ represents a time.

The vehicle cumulative throughput of capacity at the upload time point is:

$$Q_{accAH}(t_1) = Q_{accAH}^0 + \int_0^{t_1} I dt \quad , \tag{2}$$

where $Q_{accAH}^0$ represents a cumulative charge and discharge capacity at the initial time point.

Specifically, in the embodiments of the present disclosure, state parameters of the battery, including signals such as temperature, voltage, current, pressure, etc., can be collected through a vehicle BMS slave board. Data can be transmitted to a master board through a master-slave board communication protocol to perform a SOC calculation and a calculation of the cumulative charge and discharge capacity on the master board. The collected data such as the current, the voltage (Vcell1, Vcell2, ... Vcelln), the temperature, etc., and the calculated data such as BCUSOC (i.e., the vehicle SOC at the upload time point), the vehicle cumulative throughput of capacity at the upload time point $Q_{accAH}$, the full charge correction flag at the upload time point charCCVnr, the full discharge correction flag at the upload time point discharCCVnr, etc., are transmitted to Telematics-BOX, TBOX, through Controller Area Network, CAN, protocol. The TBOX analyzes the data and transmits the data to a cloud server through wireless communication technology.

It should be noted that in the embodiments of the present disclosure, based on a real-time current value, a vehicle BMS master board can integrate and calculate the SOC of the battery, that is, BCUSOC $(t_1)$. The vehicle cumulative throughput of capacity at the upload time point $Q_{accAH}(t_1)$ is calculated based on the Ampere Hour Integration Method. In equations (1) and (2), when the current $I > 0$, indicating a charge state; when $I < 0$, indicating a discharge state.

In step S102, input the battery data into the predetermined electrochemical model to obtain the cloud SOC of the battery, and determine the absolute value of the difference between the cloud SOC and the vehicle SOC at the upload time point whether greater than the first predetermined value and it is determined whether the full charge correction flag and the full discharge correction flag are both of the second predetermined value.

In the embodiments of the present disclosure, the first predetermined value is used as a calibration value of the difference between the cloud SOC and the vehicle SOC. The second predetermined value is used to determine whether the full charge correction flag and the full discharge correction flag are consistent with the calibration value. In addition, the first predetermined value and the second predetermined value may be predetermined values set by those skilled in the art, values obtained by a limited number of experiments, or values obtained by a limited number of computer simulations, respectively, and are not specifically limited here.

Further, in some embodiments, the battery data further includes a charge voltage curve and a discharge voltage curve. The predetermined electrochemical model includes a temperature field model, an internal resistance model, an electro motive force model, and an equivalent circuit model.

Specifically, the cloud server can analyze the data based on the predetermined electrochemical model, and perform a calculation based on an analysis result to obtain the cloud SOC of the battery subsequent to the cloud server receives the battery data uploaded by the vehicle. Cloud calculation includes the temperature field model, the electro motive force model, the internal resistance model, the equivalent circuit model, a diagnostic algorithm, a safety monitoring algorithm, etc., to calculate and output the state of charge of the battery (i.e., the cloud SOC).

Further, in some embodiments, said inputting the battery data into the predetermined electrochemical model to obtain the cloud SOC of the battery includes: calculating a real-time temperature of the battery based on the temperature field model, and calculating an internal resistance of the battery based on the internal resistance model and the real-time temperature; calculating an electro motive force during charging of the battery and an electro motive force during discharging of the battery based on the electro motive force model, the charge voltage curve, and the discharge voltage curve; and calculating the cloud SOC of the battery based on the equivalent circuit model using the internal resistance, the electro motive force during the charging, and the electro motive force during the discharging.

In some embodiments, the electro motive force model is:

$$V_{EMF}^{ch} = V_{ch} - \eta_{ch} \tag{3}$$

$$V_{EMF}^{d} = V_d + \eta_d \tag{4}$$

where $V_{EMF}^{ch}$ represents the electro motive force during the charging, $V_{EMF}^{d}$ represents the electro motive force during the discharging, $V_{ch}$ represents the charge voltage curve, $V_d$ represents the discharge voltage curve, $\eta_{ch}$ represents charge overpotential, and $\eta_d$ represents discharge overpotential.

In some embodiments, the equivalent circuit model is:

$$V_{ch}\left(x_0 + \frac{\int_0^t I dt}{Q_b}\right) - IR\left(\frac{Q_0}{Q_b}\frac{\int_0^t I dt}{Q_0}, I\right) = V_{EMF}^{ch}\left(\frac{Q_0}{Q_b}\frac{\int_0^t I dt}{Q_0}\right) \tag{5}$$

or

$$V_d\left(x_0 + \frac{\int_0^t I dt}{Q_b}\right) - IR\left(\frac{Q_0}{Q_b}\frac{\int_0^t I dt}{Q_0}, I\right) = V_{EMF}^d\left(\frac{Q_0}{Q_b}\frac{\int_0^t I dt}{Q_0}\right) \tag{6}$$

where $V_{ch}$ represents an actual charge voltage curve of the battery, $V_d$ represents an actual discharge voltage curve of the battery, $x_0$ represents a SOC value at a time point of uploading the battery data, $Q_0$ represents an initial capacity of a battery cell, $Q_b$ represents a real capacity of the battery cell at any time point, I represents the real-time current value of the battery, and R represents the internal resistance of the battery.

Specifically, calculations can be performed as follows subsequent to the cloud receives the data uploaded by the vehicle.

① A temperature calculation.

In the embodiments of the present disclosure, the real-time temperature T of the battery can be calculated by combining parameters such as a fluid temperature $T_0$ of the battery cell heating or cooling, heat capacity C of the battery, heat transfer coefficient H, and battery cell mass $m$ in a battery thermal management strategy through the following temperature field model (equation (7)):

$$Cm\frac{\partial T}{\partial t} = I^2 R - H(T - T_0) \tag{7}$$

② An internal resistance calculation.

The internal resistance R of the battery is a function of parameters such as the temperature, the current, the SOC (x), an aging time $t$, etc., which can be expressed as:

$$R = f(x, T, I, t) \tag{8}$$

The internal resistance includes three parts: a charge transfer internal resistance $R_{ct}$, a mass transfer internal resistance $R_{mt}$, and an ohmic internal resistance $R_\Omega$. $R_{ct}$ can be obtained through equation (9):

$$I = j_0\left(exp\left(\frac{\alpha F \eta_{ct}}{RT}\right) - exp\left(\frac{-\beta F \eta_{ct}}{RT}\right)\right) \tag{9}$$

$$R_{ct} = \frac{\partial \eta_{ct}}{\partial I} \tag{10}$$

$R_\Omega$ can be obtained during a battery cell parameter calibration test and is a function of the SOC and the aging time. $R_\Omega$ is expressed as:

$$R_\Omega = f(x, t) \tag{11}$$

$R_{mt}$ can be obtained through a mass transfer equation:

$$\frac{\partial C}{\partial t} = \nabla C \tag{12}$$

$$\eta_{mt} = 2t_+ \frac{RT}{F} \ln \frac{C_1}{C_2} \tag{13}$$

$$R_{mt} = \frac{\partial \eta_{mt}}{\partial j} \tag{14}$$

$$R_{mt} = \frac{\partial \eta_{mt}}{\partial I} \tag{15}$$

Therefore, the internal resistance of the battery is:

$$R = R_{ct} + R_{\Omega} + R_{mt} \tag{16}$$

@ An Electro Motive Force (EMF) calculation.

The electro motive force ( $V_{EMF}^{ch}$ ) during the charging of the battery and the electro motive force ( $V_{EMF}^{d}$ ) during the discharging of the battery can be calculated through the above-described equations (3) and (4), respectively.

④ A cloud SOC calculation.

The cloud SOC of the battery can be calculated through the above-described equations (5) and (6).

In step S103, when the absolute value of the difference between the cloud SOC and the vehicle SOC at the upload time point is greater than the first predetermined value and the full charge correction flag and the full discharge correction flag are both of the second predetermined value, transmit the cloud SOC to the current vehicle, allowing the current vehicle to correct the current vehicle SOC based on the cloud SOC, the cumulative throughput of capacity at the time point of receiving the cloud SOC, and the vehicle cumulative throughput of capacity at the upload time point.

Specifically, the cloud can synchronously calculate the difference ΔSOC between the cloud SOC and the vehicle SOC (i.e., BCUSOC) at the upload time point, that is, ΔSOC=CloudSOC-BCUSOC, and compare the absolute value of the ΔSOC with the first predetermined value. Preferably, as a possible implementation, in the embodiments of the present disclosure, the first predetermined value is set as 5% and the second predetermined value is set as 0. When | ΔSOC |> 5% and charCCVnr = discharCCVnr = 0, it is considered that a cloud correction condition is satisfied, and the CloudSOC and the vehicle cumulative throughput of capacity $Q_{accAH}$ at a same time point can be issued to the current vehicle. Otherwise, when | ΔSOC | ≤ 5%, the cloud SOC and the $Q_{accAH}$ are not issued. Further, a current vehicle BMS master controller corrects the current vehicle SOC based on the cloud SOC, the cumulative throughput of capacity at the time point of receiving the cloud SOC, and the vehicle cumulative throughput of capacity at the upload time point sequent to the current vehicle BMS master controller receives the cloud SOC and the $Q_{accAH}$.

To facilitate those skilled in the art to further understand the method for correcting the SOC of the battery in real time provided in the embodiments of the present disclosure, further description will be made below with reference to FIG. 2.

As illustrated in FIG. 2, FIG. 2 is a flowchart of a method for correcting a SOC of a battery in real time according to an embodiment of the present disclosure. The method includes the following steps.

In step S201, a vehicle BMS collects and uploads the battery data. The battery data is data of a Lithium Iron Phosphate (LFP) battery.

Specifically, the vehicle uploads a battery cell voltage signal (i.e. Vcell1, Vcell2, ... Vcelln), a SOC signal (i.e. the vehicle SOC at the upload time point: BCUSOC), the cumulative throughput of capacity $Q_{accAH}$, the full charge correction flag charCCVnr, the full discharge correction flag discharCCVnr, the charge/discharge voltage curve, etc., to the cloud.

It should be noted that, when the full charge (or the full discharge) correction occurs, charCCVnr = 1 (or discharCCVnr = 1). When the full charge (or the full discharge) correction does not occur, charCCVnr = 0 (or discharCCVnr = 0).

In step S202, the cloud calculates an accurate SOC value through the electrochemical model.

Specifically, the cloud server receives and analyzes uploaded signal data, and performs a calculation based on an analysis result. The cloud calculation includes the temperature field model, the electro motive force model, the internal resistance model, the equivalent circuit model, the diagnosis algorithm, the safety monitoring algorithm, etc., to calculate and output a cloud SOC value of the battery.

In step S203, the cloud determines whether or not to issue a SOC correction value to the vehicle based on the difference ($\Delta$SOC) between the vehicle and the cloud SOC and the full charge correction flag and full discharge correction flag.

Specifically, at the same time point, a difference between the SOC value obtained by the vehicle and the SOC value obtain by the cloud is calculated through : $\Delta$SOC = CloudSOC-BCUSOC. When | $\Delta$SOC |> 5% and charCCVnr = 0 and discharCCVnr = 0, it is considered that the cloud correction condition is satisfied, and the cloud SOC and the cumulative throughput of capacity $Q_{accAH}$ at the same time point are simultaneously issued to the vehicle.

In step S204, the vehicle performs a correction based on a correction value strategy subsequent to the vehicle receives a correction value issued by the cloud.

Specifically, a difference is made with a $Q_{accAH}$ value in real time calculated by the vehicle subsequent to the vehicle receives a $Q_{accAH}$ signal, where $\Delta Q=Q_{accAH}$ (the cumulative throughput of capacity at the time point of receiving the cloud SOC) - $Q_{accAH}$ (the vehicle cumulative throughput of capacity at the upload time point). The BCUSOC can be used to correct the SOC of the battery based on the following equation: BCUSOC (in real time)=CloudSOC+$\Delta Q$ /$Q_0$.

In the embodiments of the present disclosure, based on the method for correcting the SOC of the battery in real time, the battery data of the current vehicle is input into the predetermined electrochemical model to obtain the cloud SOC of the battery. When the absolute value of the difference between the cloud SOC and the vehicle SOC at the upload time point is determined to be greater than the first predetermined value and the full charge correction flag and the full discharge correction flag are both of the second predetermined value, the current vehicle SOC is corrected based on the cloud SOC, the cumulative throughput of capacity at the time point of receiving the cloud SOC, and the vehicle cumulative throughput of capacity at the upload time point. In this way, the problem that the SOC cannot be corrected in real time when the using interval of the user is the voltage platform region and the problem that the SOC error in the entire using interval of the battery is large are solved, which corrects the calculation error of the SOC in real time and improves the user experience.

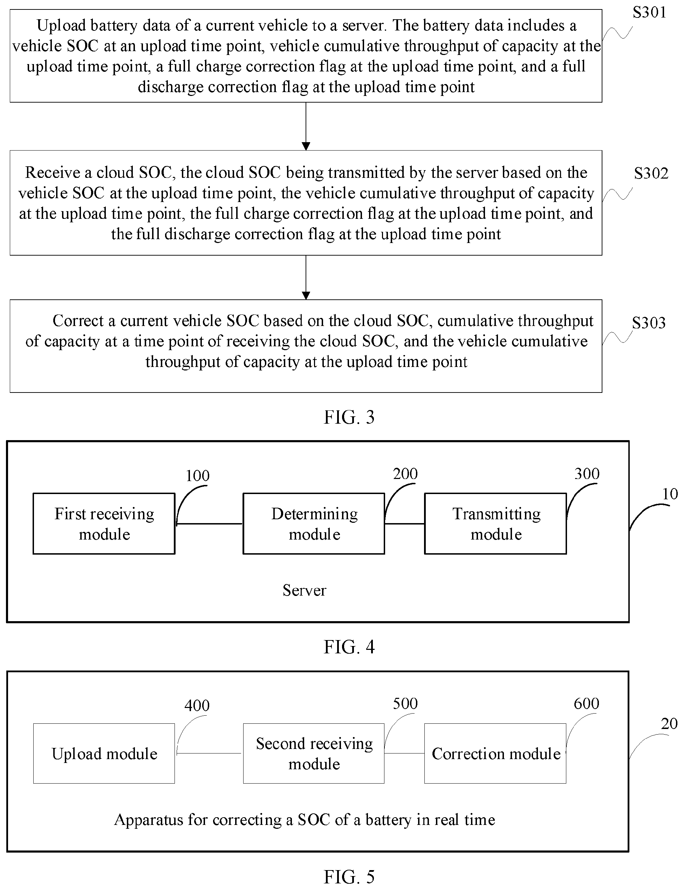

In addition, FIG. 3 is a flowchart of another method for correcting a SOC of a battery in real time according to the embodiments of the present disclosure.

As illustrated in FIG. 3, the method for correcting the SOC of the battery in real time is applied in the vehicle. The method includes the following steps.

In step S301, upload the battery data of the current vehicle to the server. The battery data includes the vehicle SOC at the upload time point, the cumulative throughput of capacity at the upload time point, the full charge correction flag at the upload time point, and the full discharge correction flag at the upload time point.

Specifically, in the embodiments of the present disclosure, the state parameters of the battery can be collected through the vehicle BMS slave board. The data is transmitted to the master board through the master-slave board communication protocol to perform the SOC calculation and the calculation of the cumulative charge and discharge capacity on the master board. The calculated vehicle SOC at the upload time point, the cumulative throughput of capacity at the upload time point, the full charge correction flag at the upload time point, and the full discharge correction flag at the upload time point, are transmitted to the server.

In step S302, receive the cloud SOC, the cloud SOC being transmitted by the server based on the vehicle SOC at the upload time point, the cumulative throughput of capacity at the upload time point, the full charge correction flag at the upload time point, and the full discharge correction flag at the upload time point.

Specifically, the cloud server receives and analyzes the upload data, and performs the calculation based on the analysis result to calculate and output the cloud SOC.

In step S303, correct the current vehicle SOC based on the cloud SOC, the cumulative throughput of capacity at the time point of receiving the cloud SOC, and the accumulated vehicle capacity throughput at the upload time point.

Specifically, the vehicle BMS master controller can correct the current vehicle SOC based on the received cloud SOC, the cumulative throughput of capacity at the time point of receiving the cloud SOC, and the vehicle cumulative throughput of capacity at the upload time point.

Further, in some embodiments, the correcting the current vehicle SOC based on the cloud SOC, the cumulative throughput of capacity at the time point of receiving the cloud SOC, and the vehicle cumulative throughput of capacity at the upload time point includes: calculating a difference between the cumulative throughput of capacity at the time point of receiving the cloud SOC and the vehicle cumulative throughput of capacity at the upload time point; calculating a ratio of the difference between the cumulative throughput of capacity at the time point of receiving the cloud SOC and the vehicle cumulative throughput of capacity at the upload time point to a battery standard capacity, and obtaining a SOC correction value of the battery based on a sum of the ratio and the cloud SOC; and correcting the SOC of the battery based on the SOC correction value.

Specifically, subsequent to the current vehicle receives the vehicle cumulative throughput of capacity $Q_{accAH}$ at the upload time point, the difference between the received vehicle cumulative throughput of capacity $Q_{accAH}$ at the upload time point and the cumulative throughput of capacity $Q_{accAH}$ at the time point of receiving the cloud SOC is made, i.e., $\triangle Q = Q_{accAH}$ (the cumulative throughput of capacity at the time point of receiving the cloud SOC) - $Q_{accAH}$ (the cumulative throughput of capacity throughput at the upload time point). The ratio of the difference between the cumulative throughput of capacity at the time point of receiving the cloud SOC and the vehicle cumulative throughput of capacity at the upload time point to the battery standard capacity is calculated, i.e., $\triangle Q / Q_0$. The SOC correction value of the battery is obtained based on the sum of the ratio and the cloud SOC, i.e., BCUSOC (in real time) =CloudSOC+$\triangle Q / Q_0$. In this way, the SOC of the battery is corrected based on the SOC correction value, where $Q_0$ represents the battery standard capacity.

In the embodiments of the present disclosure, based on the method for correcting the SOC of the battery in real time, the battery data of the current vehicle is uploaded to the server. The cloud SOC transmitted by the server is received based on the vehicle SOC at the upload time point, the vehicle cumulative throughput of capacity at the upload time point, the full charge correction flag at the upload time point, and the full discharge correction flag at the upload time point. The current vehicle SOC is corrected based on the cloud SOC, the cumulative throughput of capacity at the time point of receiving the cloud SOC, and the vehicle cumulative throughput of capacity at the upload time point. In this way, the problem that the SOC cannot be corrected in real time when the using interval of the user is the voltage platform region and the problem that the SOC error in the entire using interval of the battery is large are solved, which corrects the calculation error of the SOC in real time and improves the user experience.

Further, a server according to the embodiments of the present disclosure is described with reference to the accompanying drawings.

As illustrated in FIG. 4, FIG. 4 is a block diagram of the server according to the embodiments of the present disclosure. The server 10 includes a receiving module 100, a determining module 200, and a transmitting module 300.

The receiving module 100 is configured to receive the battery data uploaded by the current vehicle. The battery data includes the vehicle SOC at the upload time point, the vehicle cumulative throughput of capacity at the upload time point, the full charge correction flag at the upload time point, and the full discharge correction flag at the upload time point.

The determining module 200 is configured to input the battery data into the predetermined electrochemical model to obtain the cloud SOC of the battery, and determine whether the absolute value of the difference between the cloud SOC and the vehicle SOC at the upload time point is greater than the first predetermined value and whether the full charge correction flag and the full discharge correction flag are both of the second predetermined value.

The transmitting module 300 is configured to transmit the cloud SOC to the current vehicle when the absolute value of the difference between the cloud SOC and the vehicle SOC at the upload time point is greater than the first predetermined value and the full charge correction flag and the full discharge correction flag are both of the second predetermined value, allowing the current vehicle to correct the current vehicle SOC based on the cloud SOC, the cumulative throughput of capacity at the time point of receiving the cloud SOC, and the vehicle cumulative throughput of capacity at the upload time point.

Further, in some embodiments, the battery data further includes the charge voltage curve and the discharge voltage curve.

The predetermined electrochemical model includes the temperature field model, the internal resistance model, the electro motive force model, and the equivalent circuit model.

Further, in some embodiments, the determining module 200 is configured to: calculate the real-time temperature of the battery based on the temperature field model, and calculate the internal resistance of the battery based on the internal resistance model and the real-time temperature; calculate the electro motive force during the charging of the battery and the electro motive force during the discharging of the battery based on the electro motive force model, the charge voltage curve, and the discharge voltage curve; and calculate the cloud SOC of the battery based on the equivalent circuit model using the internal resistance, the electro motive force during the charging, and the electro motive force during the discharging.

Further, in some embodiments, the equivalent circuit model is:

$$V_{ch}\left(x_0 + \frac{\int_0^t I dt}{Q_b}\right) - IR\left(\frac{Q_0}{Q_b}\frac{\int_0^t I dt}{Q_0}, I\right) = V_{EMF}^{ch}\left(\frac{Q_0}{Q_b}\frac{\int_0^t I dt}{Q_0}\right),$$

or

$$V_d\left(x_0 + \frac{\int_0^t Idt}{Q_b}\right) - IR\left(\frac{Q_0}{Q_b}\frac{\int_0^t Idt}{Q_0}, I\right) = V_{EMF}^d\left(\frac{Q_0}{Q_b}\frac{\int_0^t Idt}{Q_0}\right)$$

where $V_{ch}$ represents the actual charge voltage curve of the battery, $V_d$ represents the actual discharge voltage curve of the battery, $x_0$ represents the SOC value at the time point of uploading the battery data, $Q_0$ represents the initial capacity of the battery cell, $Q_b$ represents the real capacity of the battery cell at any time point, I represents the real-time current value of the battery, R represents the internal resistance of the battery, $V_{EMF}^{rch}$ represents the electro motive force during the charging, and $V_{EMF}^d$ represents the electro motive force during the discharging.

Further, the electro motive force model is:

$$V_{EMF}^{ch} = V_{ch} - \eta_{ch}$$

and

$$V_{EMF}^d = V_d + \eta_d$$

where $\eta_{ch}$ represents the charge overpotential, and $\eta_d$ represents the discharge overpotential.

Further, the vehicle SOC at the upload time point is:

$$BCUSOC(t_1) = x_0 + \frac{\int_0^{t_1} Idt}{Q_0}$$

where $x_0$ represents the SOC value of the battery system at the initial time point, $Q_0$ represents the battery standard capacity, and $t_1$ represents the time.

The vehicle cumulative throughput of capacity at the upload time point is:

$$Q_{accAH}(t_1) = Q_{accAH}^0 + \int_0^{t_1} Idt$$

where $Q_{accAH}^0$ represents the cumulative charge and discharge capacity at the initial time point.

It should be noted that the above explanation of the embodiments of the method for correcting the SOC of the battery in real time is also applicable to the server of the embodiment, and will not be repeated here.

Based on the server provided in the embodiments of the present disclosure, the battery data of the current vehicle is input into the predetermined electrochemical model to obtain the cloud SOC of the battery. When the absolute value of the difference between the cloud SOC and the vehicle SOC at the upload time point is determined to be greater than the first predetermined value and the full charge correction flag and the full discharge correction flag are both of the second predetermined value, the current vehicle SOC is corrected based on the cloud SOC, the accumulated capacity throughput at the time point of receiving the cloud SOC, and the accumulated vehicle capacity throughput at the upload time point. In this way, the problem that the SOC cannot be corrected in real time when the using interval of the user is the voltage platform region and the problem that the SOC error in the entire using interval of the battery is large are solved, which corrects the calculation error of the SOC in real time and improves the user experience.

Further, an apparatus for correcting the SOC of the battery in real time according to the embodiments of the present disclosure is described with reference to the accompanying drawings.

FIG. 5 is a block diagram of the apparatus for correcting the SOC of the battery in real time according to the embodiments of the present disclosure. The apparatus is applied in a vehicle.

As illustrated in FIG. 5, the apparatus 20 for correcting the SOC of the battery in real time includes an upload module 400, a second receiving module 500, and a correction module 600.

The upload module 400 is configured to upload the battery data of the current vehicle, and transmit the battery data to the server. The battery data includes the vehicle SOC at the upload time point, the vehicle cumulative throughput of capacity at the upload time point, the full charge correction flag at the upload time point, and the full discharge correction flag at the upload time point.

The second receiving module 500 is configured to receive the cloud SOC, the cloud SOC being transmitted by the server based on the vehicle SOC at the upload time point, the vehicle cumulative throughput of capacity at the upload time point, the full charge correction flag at the upload time point, and the full discharge correction flag at the upload time point.

The correction module 600 is configured to correct the current vehicle SOC based on the cloud SOC, the cumulative throughput of capacity at the time point of receiving the cloud SOC, and the vehicle cumulative throughput of capacity at the upload time point.

Further, in some embodiments, the correction module 600 is configured to: calculate the difference between the cumulative throughput of capacity at the time point of receiving the cloud SOC and the vehicle cumulative throughput of capacity at the upload time point; calculate the ratio of the difference between the cumulative throughput of capacity at the time point of receiving the cloud SOC and the vehicle cumulative throughput of capacity at the upload time point to the battery standard capacity, and obtain the SOC correction value of the battery based on the sum of the ratio and the cloud SOC; and correct the SOC of the battery based on the SOC correction value.

It should be noted that the above explanation of the embodiments of the method for correcting the SOC of the battery in real time is also applicable to the apparatus for correcting the SOC of the battery in real time of the embodiment, and will not be repeated here.

Based on the apparatus for correcting the SOC of the battery in real time provided in the embodiments of the present disclosure, the battery data of the current vehicle is uploaded to the server. The cloud SOC is received, the cloud SOC being transmitted by the server based on the vehicle SOC at the upload time point, the vehicle cumulative throughput of capacity at the upload time point, the full charge correction flag at the upload time point, and the full discharge correction flag at the upload time point. The current vehicle SOC is corrected based on the cloud SOC, the cumulative throughput of capacity at the time point of receiving the cloud SOC, and the vehicle cumulative throughput of capacity at the upload time point. In this way, the problem that the SOC cannot be corrected in real time when the using interval of the user is the voltage platform region and the problem that the SOC error in the entire using interval of the battery is large are solved, which corrects the calculation error of the SOC in real time and improves the user experience.

In the embodiments of the present disclosure, a vehicle is provided. The vehicle includes the above-described apparatus for correcting the SOC of the battery in real time.

Based on the vehicle provided in the embodiments of the present disclosure, the problem that the SOC cannot be corrected in real time when the using interval of the user is the voltage platform region and the problem that the SOC error in the entire using interval of the battery is large are solved through the apparatus for correcting the SOC of the battery in real time, which corrects the calculation error of the SOC in real time and improves the user experience.

In the embodiments of the present disclosure, a computer-readable storage medium is provided. The computer-readable storage medium stores a computer program. The computer program, when executed by a processor, implements the method for correcting the SOC of the battery in real time according to the embodiment of FIG. 1 or the method for correcting the SOC of the battery in real time according to the embodiment of FIG. 3.

The above embodiments are merely preferred embodiments for fully illustrating the present disclosure and the protection scope of the present disclosure is not limited thereto. Equivalent replacements or changes made by those skilled in the art based on the present disclosure are within the protection scope of the present disclosure.

**Claims**

1. A method for correcting a State of Charge, SOC, of a battery in real time, the method being applied in a server and comprising:

    receiving battery data uploaded by a current vehicle, the battery data comprising a vehicle SOC at an upload time point, a vehicle cumulative throughput of capacity at the upload time point, a full charge correction flag at the upload time point, and a full discharge correction flag at the upload time point;
    inputting the battery data into a predetermined electrochemical model to obtain a cloud SOC of the battery, and determining whether an absolute value of a difference between the cloud SOC and the vehicle SOC at the upload time point is greater than a first predetermined value and whether the full charge correction flag and the full discharge correction flag are both of a second predetermined value; and
    when the absolute value of the difference between the cloud SOC and the vehicle SOC at the upload time point is greater than the first predetermined value and the full charge correction flag and the full discharge correction flag are both of the second predetermined value, transmitting the cloud SOC to the current vehicle, allowing the current vehicle to correct a current vehicle SOC based on the cloud SOC, a cumulative throughput of capacity at a time point of receiving the cloud SOC, and the vehicle cumulative throughput of capacity at the upload time point.

2. The method according to claim 1, wherein:

the battery data further comprises a charge voltage curve and a discharge voltage curve; and
the predetermined electrochemical model comprises a temperature field model, an internal resistance model, an electro motive force model, and an equivalent circuit model.

3. The method according to claim 2, wherein said inputting the battery data into the predetermined electrochemical model to obtain the cloud SOC of the battery comprises:

calculating a real-time temperature of the battery based on the temperature field model, and calculating an internal resistance of the battery based on the internal resistance model and the real-time temperature;
calculating an electro motive force during charging of the battery and an electro motive force during discharging of the battery based on the electro motive force model, the charge voltage curve, and the discharge voltage curve; and
calculating the cloud SOC of the battery based on the equivalent circuit model using the internal resistance, the electro motive force during the charging, and the electro motive force during the discharging.

4. The method according to claim 3, wherein the equivalent circuit model is:

$$V_{ch}\left(x_0 + \frac{\int_0^t I dt}{Q_b}\right) - IR\left(\frac{Q_0}{Q_b}\frac{\int_0^t I dt}{Q_0}, I\right) = V_{EMF}^{ch}\left(\frac{Q_0}{Q_b}\frac{\int_0^t I dt}{Q_0}\right),$$

or

$$V_d\left(x_0 + \frac{\int_0^t I dt}{Q_b}\right) - IR\left(\frac{Q_0}{Q_b}\frac{\int_0^t I dt}{Q_0}, I\right) = V_{EMF}^d\left(\frac{Q_0}{Q_b}\frac{\int_0^t I dt}{Q_0}\right),$$

where $V_{ch}$ represents an actual charge voltage curve of the battery, $V_d$ represents an actual discharge voltage curve of the battery, $x_0$ represents a SOC value at a time point of uploading the battery data, $Q_0$ represents an initial capacity of a battery cell, $Q_b$ represents a real capacity of the battery cell at any time point, I represents a real-time current value of the battery, R represents the internal resistance of the battery, $V_{EMF}^{ch}$ represents the electro motive force during the charging, and $V_{EMF}^d$ represents the electro motive force during the discharging.

5. The method according to claim 3, wherein the electro motive force model is:

$$V_{EMF}^{ch} = V_{ch} - \eta_{ch};$$

and

$$V_{EMF}^d = V_d + \eta_d,$$

where $\eta_{ch}$ represents charge overpotential, and $\eta_d$ represents discharge overpotential.

6. The method according to claim 1, wherein:

the vehicle SOC at the upload time point is:

$$BCUSOC(t_1) = x_0 + \frac{\int_0^{t_1} I dt}{Q_0},$$

where $x_0$ represents a SOC value of a battery system at an initial time point, $Q_0$ represents a battery standard capacity, and $t_1$ represents a time; and
the vehicle cumulative throughput of capacity at the upload time point is:

$$Q_{accAH}(t_1) = Q_{accAH}^0 + \int_0^{t_1} I dt,$$

where $Q_{accAH}^0$ represents a cumulative charge and discharge capacity at the initial time point.

7. A method for correcting a State of Charge, SOC, of a battery in real time, the method being applied in a vehicle and comprising:

uploading battery data of a current vehicle to a server, the battery data comprising a vehicle SOC at an upload time point, a vehicle cumulative throughput of capacity at the upload time point, a full charge correction flag at the upload time point, and a full discharge correction flag at the upload time point;
receiving a cloud SOC, the cloud SOC being transmitted by the server based on the vehicle SOC at the upload time point, the vehicle cumulative throughput of capacity at the upload time point, the full charge correction flag at the upload time point, and the full discharge correction flag at the upload time point; and
correcting a current vehicle SOC based on the cloud SOC, a cumulative throughput of capacity at a time point of receiving the cloud SOC, and the vehicle cumulative throughput of capacity at the upload time point.

8. The method according to claim 7, wherein said correcting the current vehicle SOC based on the cloud SOC, the cumulative throughput of capacity at the time point of receiving the cloud SOC, and the vehicle cumulative throughput of capacity at the upload time point comprises:

calculating a difference between the cumulative throughput of capacity at the time point of receiving the cloud SOC and the vehicle cumulative throughput of capacity at the upload time point;
calculating a ratio of the difference between the cumulative throughput of capacity at the time point of receiving the cloud SOC and the vehicle cumulative throughput of capacity at the upload time point to a battery standard capacity, and obtaining a SOC correction value of the battery based on a sum of the ratio and the cloud SOC; and
correcting the SOC of the battery based on the SOC correction value.

9. A server, comprising:

a first receiving module configured to receive battery data uploaded by a current vehicle, the battery data comprising a vehicle SOC at an upload time point, a vehicle cumulative throughput of capacity at the upload time point, a full charge correction flag at the upload time point, and a full discharge correction flag at the upload time point;
a determining module configured to input the battery data into a predetermined electrochemical model to obtain a cloud SOC of the battery, and determine whether an absolute value of a difference between the cloud SOC and the vehicle SOC at the upload time point is greater than a first predetermined value and whether the full charge correction flag and the full discharge correction flag are both of a second predetermined value; and
a transmitting module configured to transmit the cloud SOC to the current vehicle when the absolute value of the difference between the cloud SOC and the vehicle SOC at the upload time point is greater than the first predetermined value and the full charge correction flag and the full discharge correction flag are both of the second predetermined value, allowing the current vehicle to correct a current vehicle SOC based on the cloud SOC, a cumulative throughput of capacity at a time point of receiving the cloud SOC, and the vehicle cumulative throughput of capacity at the upload time point.

10. The server according to claim 9, wherein:

the battery data further comprises a charge voltage curve and a discharge voltage curve; and
the predetermined electrochemical model comprises a temperature field model, an internal resistance model, an electro motive force model, and an equivalent circuit model.

11. The server according to claim 10, wherein the determining module is configured to:

calculate a real-time temperature of the battery based on the temperature field model, and calculate an internal resistance of the battery based on the internal resistance model and the real-time temperature;
calculate an electro motive force during charging of the battery and an electro motive force during discharging of the battery based on the electro motive force model, the charge voltage curve, and the discharge voltage curve; and
calculate the cloud SOC of the battery based on the equivalent circuit model using the internal resistance, the electro motive force during the charging, and the electro motive force during the discharging.

12. The server according to claim 11, wherein the equivalent circuit model is:

$$V_{ch}\left(x_0 + \frac{\int_0^t I dt}{Q_b}\right) - IR\left(\frac{Q_0}{Q_b}\frac{\int_0^t I dt}{Q_0}, I\right) = V_{EMF}^{ch}\left(\frac{Q_0}{Q_b}\frac{\int_0^t I dt}{Q_0}\right),$$

or

$$V_d\left(x_0 + \frac{\int_0^t I dt}{Q_b}\right) - IR\left(\frac{Q_0}{Q_b}\frac{\int_0^t I dt}{Q_0}, I\right) = V_{EMF}^d\left(\frac{Q_0}{Q_b}\frac{\int_0^t I dt}{Q_0}\right),$$

where $V_{ch}$ represents an actual charge voltage curve of the battery, $V_d$ represents an actual discharge voltage curve of the battery, $x_0$ represents a SOC value at a time point of uploading the battery data, $Q_0$ represents an initial capacity of a battery cell, $Q_b$ represents a real capacity of the battery cell at any time point, I represents a real-time current value of the battery, R represents the internal resistance of the battery, $V_{EMF}^{ch}$ represents the electro motive force during the charging, and $V_{EMF}^d$ represents the electro motive force during the discharging.

13. The server according to claim 11, wherein the electro motive force model is:

$$V_{EMF}^{ch} = V_{ch} - \eta_{ch};$$

and

$$V_{EMF}^d = V_d + \eta_d,$$

where $\eta_{ch}$ represents charge overpotential, and $\eta_d$ represents discharge overpotential.

14. The server according to claim 9, wherein:

the vehicle SOC at the upload time point is:

$$BCUSOC(t_1) = x_0 + \frac{\int_0^{t_1} I dt}{Q_0},$$

where $x_0$ represents a SOC value of a battery system at an initial time point, $Q_0$ represents a battery standard capacity, and $t_1$ represents a time; and
the vehicle cumulative throughput of capacity at the upload time point is:

$$Q_{accAH}(t_1) = Q_{accAH}^0 + \int_0^{t_1} I dt$$

where $Q_{accAH}^0$ represents a cumulative charge and discharge capacity at the initial time point.

15. An apparatus for correcting a State of Charge, SOC, of a battery in real time, the apparatus being applied in a vehicle and comprising:

an upload module configured to upload battery data of a current vehicle to a server, the battery data comprising a vehicle SOC at an upload time point, a vehicle cumulative throughput of capacity at the upload time point, a full charge correction flag at the upload time point, and a full discharge correction flag at the upload time point;
a second receiving module configured to receive a cloud SOC, the cloud SOC being transmitted by the server based on the vehicle SOC at the upload time point, the vehicle cumulative throughput of capacity at the upload time point, the full charge correction flag at the upload time point, and the full discharge correction flag at the upload time point; and
a correction module configured to correct a current vehicle SOC based on the cloud SOC, a cumulative throughput of capacity at a time point of receiving the cloud SOC, and the vehicle cumulative throughput of capacity at the upload time point.

16. The apparatus according to claim 15, wherein the correction module is configured to:

calculate a difference between the cumulative throughput of capacity at the time point of receiving the cloud SOC and the vehicle cumulative throughput of capacity at the upload time point;
calculate a ratio of the difference between the cumulative throughput of capacity at the time point of receiving the cloud SOC and the vehicle cumulative throughput of capacity at the upload time point to a battery standard capacity, and obtain a SOC correction value of the battery based on a sum of the ratio and the cloud SOC; and
correct the SOC of the battery based on the SOC correction value.

17. A vehicle comprising the apparatus for correcting the SOC of the battery in real time according to claim 15 or 16.

18. A computer-readable storage medium having a computer program stored thereon, wherein the computer program, when executed by a processor, implements the method for correcting the SOC of the battery in real time according to any one of claims 1 to 6 or the method for correcting the SOC of the battery in real time according to claim 7 or 8.

Receive battery data uploaded by a current vehicle. The battery data includes a vehicle SOC at an upload time point, accumulated vehicle capacity throughput at the upload time point, a full charge correction flag at the upload time point, and a full discharge correction flag at the upload time point

S101

Input the battery data into a predetermined electrochemical model to obtain a cloud SOC of the battery, and determine whether an absolute value of a difference between the cloud SOC and the vehicle SOC at the upload time point is greater than a first predetermined value and whether the full charge correction flag and the full discharge correction flag are both of a second predetermined value

S102

When the absolute value of the difference between the cloud SOC and the vehicle SOC at the upload time point is greater than the first predetermined value and the full charge correction flag and the full discharge correction flag are both of the second predetermined value, transmit the cloud SOC to the current vehicle, allowing the current vehicle to correct a current vehicle SOC based on the cloud SOC, cumulative throughput of capacity at a time point of receiving the cloud SOC, and the vehicle cumulative throughput of capacity at the upload time point

S103

FIG. 1

A vehicle BMS collects and uploads battery data

S201

A cloud calculates an accurate SOC value through an electrochemical model

S202

The cloud determines whether to issue a SOC correction value to a vehicle based on a difference between the vehicle SOC and the cloud SOC (ΔSOC), and full charge and full discharge correction flag

S203

The vehicle performs a correction based on a correction value strategy subsequent to the vehicle receives the correction value issued by the cloud

S204

FIG. 2

Upload battery data of a current vehicle to a server. The battery data includes a vehicle SOC at an upload time point, vehicle cumulative throughput of capacity at the upload time point, a full charge correction flag at the upload time point, and a full discharge correction flag at the upload time point

S301

Receive a cloud SOC, the cloud SOC being transmitted by the server based on the vehicle SOC at the upload time point, the vehicle cumulative throughput of capacity at the upload time point, the full charge correction flag at the upload time point, and the full discharge correction flag at the upload time point

S302

Correct a current vehicle SOC based on the cloud SOC, cumulative throughput of capacity at a time point of receiving the cloud SOC, and the vehicle cumulative throughput of capacity at the upload time point

S303

FIG. 3

| First receiving module | Determining module | Transmitting module |
| --- | --- | --- |

100   200   300   10

Server

FIG. 4

| Upload module | Second receiving module | Correction module |
| --- | --- | --- |

400   500   600   20

Apparatus for correcting a SOC of a battery in real time

FIG. 5

## INTERNATIONAL SEARCH REPORT

| International application No. |
|---|
| **PCT/CN2023/120750** |

**A.    CLASSIFICATION OF SUBJECT MATTER**

G01R31/367(2019.01)i;  B60L58/12(2019.01)i;  G01R31/382(2019.01)i

According to International Patent Classification (IPC) or to both national classification and IPC

**B.    FIELDS SEARCHED**

Minimum documentation searched (classification system followed by classification symbols)

IPC:  G01R B60L

Documentation searched other than minimum documentation to the extent that such documents are included in the fields searched

Electronic data base consulted during the international search (name of data base and, where practicable, search terms used)

CNABS; CNTXT; CNKI; VEN; WOTXT; USTXT; EPTXT; GBTXT; IEEE: 深蓝汽车科技, 李宗华, 李东江, 电池, 荷电状态, 容量, 车, 云端, 服务器, 差值, 修正, 校正, battery, cell, SOC, capacity, vehicle, cloud, server, difference, correct+

**C.    DOCUMENTS CONSIDERED TO BE RELEVANT**

| Category* | Citation of document, with indication, where appropriate, of the relevant passages | Relevant to claim No. |
|---|---|---|
| PX | CN 116609674 A (SHENLAN AUTOMOBILE TECHNOLOGY CO., LTD.) 18 August 2023 (2023-08-18)<br>claims 1-18 | 1-18 |
| X | CN 116047323 A (ZHUHAI GUANYU POWER SUPPLY CO., LTD.) 02 May 2023 (2023-05-02)<br>description, paragraphs [0027]-[0087], and figures 1-9 | 1, 2, 6-10, 14-18 |
| A | CN 108663621 A (BYD CO., LTD.) 16 October 2018 (2018-10-16)<br>entire document | 1-18 |
| A | CN 113625175 A (SHENZHEN AUTOMOTIVE RESEARCH INSTITUTE, BIT (SHENZHEN RESEARCH INSTITUTE, NATIONAL ENGINEERING LABORATORY FOR ELECTRIC VEHICLES)) 09 November 2021 (2021-11-09)<br>entire document | 1-18 |
| A | CN 115684966 A (SHITU TECHNOLOGY (HANGZHOU) CO., LTD.) 03 February 2023 (2023-02-03)<br>entire document | 1-18 |

☑ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **07 December 2023** | **11 December 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/120750**

**C.    DOCUMENTS CONSIDERED TO BE RELEVANT**

| Category* | Citation of document, with indication, where appropriate, of the relevant passages | Relevant to claim No. |
|---|---|---|
| A | US 2020278399 A1 (CHONGQING JINKANG NEW ENERGY AUTOMOBILE CO., LTD. et al.) 03 September 2020 (2020-09-03)<br>entire document | 1-18 |

Form PCT/ISA/210 (second sheet) (July 2022)

**INTERNATIONAL SEARCH REPORT**
Information on patent family members

| International application No. |
| :-- |
| **PCT/CN2023/120750** |

| Patent document cited in search report | | | Publication date (day/month/year) | Patent family member(s) | | | Publication date (day/month/year) |
| :-- | :-- | :-- | :-- | :-- | :-- | :-- | :-- |
| CN | 116609674 | A | 18 August 2023 | None | | | |
| CN | 116047323 | A | 02 May 2023 | None | | | |
| CN | 108663621 | A | 16 October 2018 | None | | | |
| CN | 113625175 | A | 09 November 2021 | None | | | |
| CN | 115684966 | A | 03 February 2023 | None | | | |
| US | 2020278399 | A1 | 03 September 2020 | US | 11585859 | B2 | 21 February 2023 |

Form PCT/ISA/210 (patent family annex) (July 2022)

**EP 4 564 027 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310612960
- CN 202211405418

- CN 201310630382